# EUROPEAN PATENT APPLICATION

(11) **EP 1 450 483 A1**
(43) Date of publication of application: **25.08.2004**
(21) Application number: 03029636.2
(22) Date of filing: 22.12.2003
(51) Int. Cl.: H03G 3/30

(54) **A method and device for controlling a power amplifier of a radio transmitter, and a mobile terminal**

(71) Applicant: SIEMENS AKTIENGESELLSCHAFT, 80333 München (DE)
(72) Inventor: Langer, Andreas, 85716 Unterschleissheim-Lohhof (DE)

(57) **Abstract**

A method for controlling a power amplifier (105) of a radio transmitter (10) having a maximum output power (P_{MAX, M}) less than the saturation power (P_{SAT, M}) of the power amplifier (105), the power amplifier (105) amplifying a signal (S) on a first number (M) of time slots in a time frame (F) comprises the steps of:
- receiving a target value (T) representing a second number (N) of time slots to be used, the second number (N) being larger or smaller than the first number (M); and
- responsive to receiving said target value (T), changing the first saturation power (P_{SAT, M}) to a second saturation power (P_{SAT, N}), wherein:
   - said second saturation power (P_{SAT, N}) is less than the first saturation power (P_{SAT, M}) if the new number (N) is larger than the old number (M); or
   - said second saturation power (P_{SAT, N}) is greater than the first saturation power (P_{SAT, M}) if the new number (N) is smaller than the old number (M).

## Description

### Field of the invention

The invention relates to power control of radio transmitters, especially such as used in mobile terminals.

### Background of the invention

During the last decade, the transmission speed for data and speech between a mobile terminal and a base station has been steadily growing. Many different methods, such as new modulation and channel coding techniques, have been under development to enable further increases in the transmission speed.

In Time Division Multiple Access TDMA systems, a given frequency is shared between multiple users by dividing a short time interval (time frame) to a number of smaller time intervals (time slots). For example, in GSM 900 MHz standards, the duration of a frame is approximately 4,6152 ms, and of a time slot 576.9 µs. A terminal transmits data to a base station by sending a burst within one specified time slot in a time frame, and receives data from the base station during another specified time slot. Another terminal communicates in respective manner with the same base station but uses different time slots for the communication.

One relatively easy and straightforward way to increase the transmission speed is to use a larger number of time slots for receiving or sending data. This has so far been used in the downlink direction (from base station to mobile terminal), mainly because the amount of information has been larger in that direction. A significant problem has also been that power consumption in the mobile terminal almost doubles when two timeslots in a frame are used for transmitting to uplink direction.

For example, in GPRS Class 10, a mobile terminal may use more than one time slot per time frame. According to a recent proposal (Change Request 05-05 CR A373) presented in 3GPP TSG-GERAN Meeting #16, it should be allowable for a mobile terminal to reduce the ouput power in two time slot uplink use (2TX use) up to 3 dB and in four time slot uplink use (4TX use) up to 6 dB.

In the past, especially the 4TX use (GPRS Class 12) appeared not technically realisable, because of high loss heating in the power amplifier. By following the idea in the Change Request, the technical realisability can be achieved.

### Summary of the invention

A power amplifier typically used in a mobile terminal obtains its maximal efficiency, typically 45-50 %, close to the saturation power of the power amplifier. For GSM 900 MHz terminals, this might be about 34 dBm.

An observation behind the invention is that when the output power would in 4TX use be reduced with 6dB, there would be a signifigant reduction in the efficiency of the power amplifier.

With a 6dB reduction in the output power, the efficiency would drop from 45% to typically only 25%. Therefore, the reduction of the power consumption is not proportional to the reduction in the transmission (RF) power, which would lead to an unnecessary high current consumption. As a consequence, the talk time would be reduced, and the power amplifier would produce more heat than necessary.

In 4TX use with output power reduced by 6dB, the power loss would be about 30-50% higher than in 1TX use with normal output power.

Therefore, an object of the invention is to bring about a method and device for controlling a power amplifier of a radio transmitter, and a mobile terminal, by using of which the transmission efficiency can be significantly improved in multislot use.

The object of controlling a power amplifier of a radio transmitter can be achieved with the method as in claims 1 to 3, or with the device as in any one of claims 4 to 6. The mobile terminal is characterized by any one of claims 7 to 10.

### Advantages of the invention

By using a device or method in accordance to the invention, it is possible to improve the efficiency of a power amplifier when the number of time slots in a time frame changes, the change implying a change in the transmission power of the transmitter.

A clear advantage of the invention is that a smaller energy consumption can be achieved. For a mobile station this implies larger use time before the battery of the mobile station has to be recharged.

### Short description of the drawings

In the following, the invention is described in more detail with reference to the examples in Figures 1 to 6B of the accompanying drawings, of which:
Figure 1 shows a simplified diagram of blocks related to the transmitting function of a mobile terminal;
Figure 2A shows a simplified diagram of a power amplifier;
Figure 2B illustrates a first embodiment of the invention, where the transmitting power is reduced or increased by changing the match in the match circuit after the last amplifier stage;
Figure 3 illustrates a second embodiment of the invention, where the transmitting power is reduced or increased by changing bias voltage V_{BIAS} in the last amplifier stage;
Figure 4 shows a third embodiment of the invention, where the transmitting power is reduced or increased by bypassing or enabling the the last amplifier stage;
Figure 5 illustrates internal control in a mobile terminal transmitting on a first number M of time slots in a time frame F, after receiving from a mobile network a command comprising a target value T representing a second number N of time slots in a time frame to be used in transmitting; and
Figures 6A and 6B show two time frames where M=2 (Fig. 6A) and N=4 (Fig. 6B).

### Detailed description of the invention

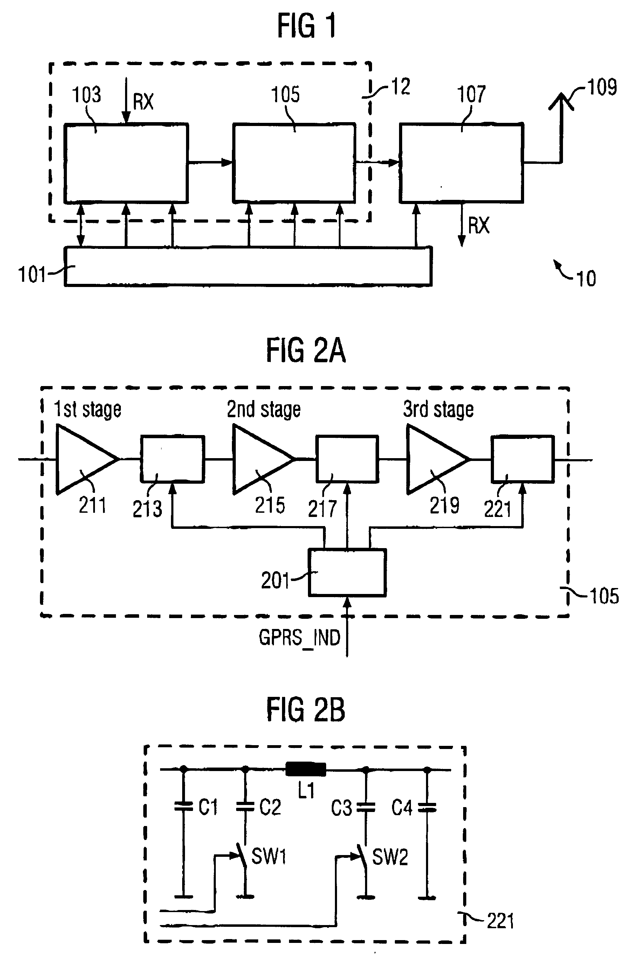

Figure 1 shows a simplified diagram of blocks related to the transmitting function of a mobile terminal 10. The mobile terminal 10 comprises a Base Band unit 101, a radio transmitter 12, front end 107, and antenna 109. The radio transmitter 12 further comprises the Radio Frequency subsystem 103 and a power amplifier 105.

Figure 2A shows a simplified diagram of a power amplifier 105. In the example in Figure 2A, the power amplifier 105 has three stages: the first stage 211, the second stage 215, and the third stage 219. After the first stage 211 there is a first match circuit 213, after the second stage 215 there is a second match circuit 217, and after the third stage 219 there is a third match circuit 221. The first, second, and third match circuits 213, 217, and 221 are controlled by a control unit 201 which is further controlled by the Base Band unit 101 via a control voltage GPRS_IND.

Figure 2B illustrates the first embodiment of the invention, showing the third match circuit 221 in more detail. The third match circuit comprises two capacitances C1 and C4, between of which there is an inductance L1. According to one embodiment of the invention, there are now added two further capacitances C2 and C3 which are controllable by switches SW1 and SW2. The switches SW1 and SW2 are then controlled by the control unit 201.

If the output power is to be reduced, i.e. if the number of time slots in a time frame to be used for transmitting increases, the output match in the third match circuit 221 is changed in such a manner that the power amplifier 105 reaches its saturation point with the lower transmitting power.

If the output power is to be increased, i.e. if the number of time slots in a time frame to be used for transmitting decreases, the output match in the third match circuit 221 is changed in such a manner that the power amplifier 105 reaches its saturation point with the higher transmitting power.

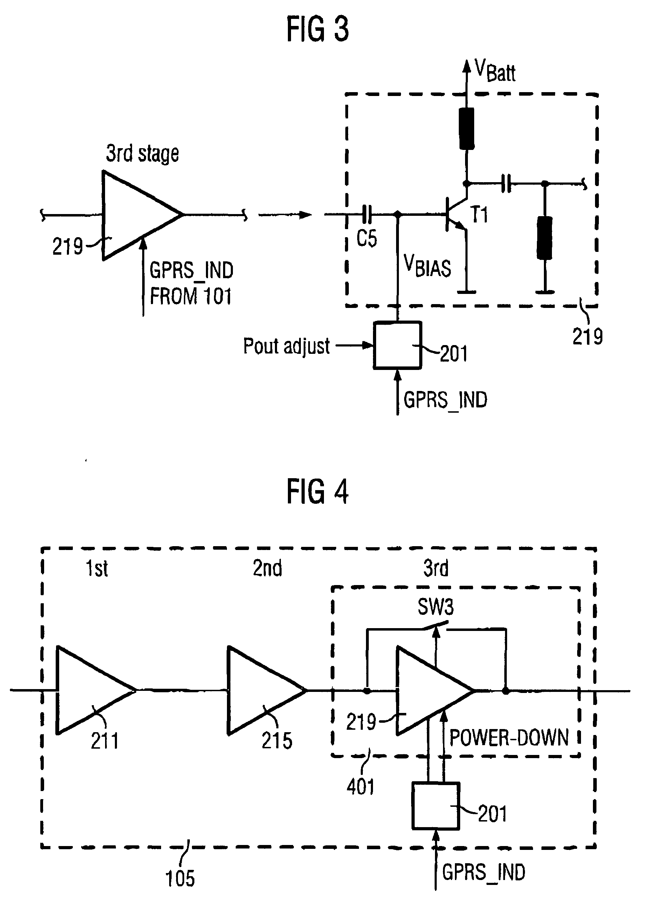

Figure 3 illustrates the second embodiment of the invention. The bias voltage V_{BIAS} in the third stage 219 is responsive to control voltage GPRS_IND from the Base Band unit 101.

Control unit 201, which in this case is a bias voltage unit, adjusts the bias voltage V_{BIAS} preferably by feeding it between the capacitance C5 and the base of the transistor T1 in response to control voltage GPRS_IND. In response to the change in the bias voltage V_{BIAS}, the current in the base of the transistor T1 decreases and therefore the amplifying of the transistor T1 decreases.

Figure 4 shows the third embodiment of the invention. The last amplifier stage 219 can be bypassed, for example by using switch SW3 the position of which is changed in response to control voltage GPRS_IND. In the example of Figure 4, the control unit 201 is responsive to the control voltage GPRS_IND. If the control voltage GPRS_IND is present, the position of the switch SW3 is changed.

All three embodiments can be used either alone or in combination with one or two of the other embodiments. In this manner, the efficiency of the power amplifier 105 can be significantly improved in the back-off use.

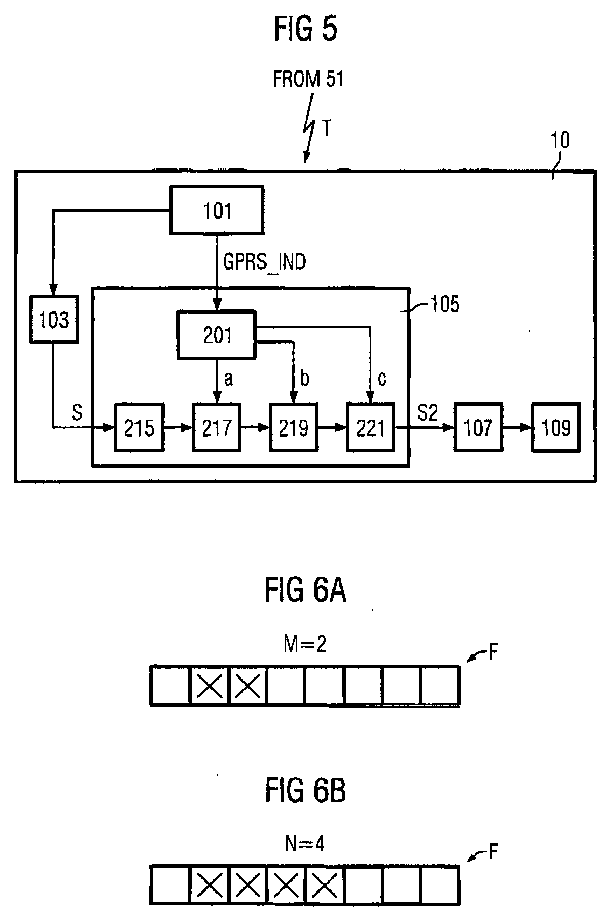

Figure 5 shows an example illustrating a manner in which the invention can be carried out in line with all three embodiments. In the following it is also referred to examples in Figures 6A and 6B.

When a mobile terminal 10 is transmitting on a first number M of time slots in a time frame F, the power amplifier 105 of the mobile terminal 10 is adapted to amplify a signal S to an amplified signal S2 with an amplification corresponding to a maximum output power P_{MAX, M}. The maximum output power P_{MAX, M} is less than the saturation power P_{SAT, M} of the power amplifier 105.

If the mobile terminal 10 receives from a mobile network 51 a command comprising a target value T representing a second number N of time slots in a time frame F, so that the new number N of time slots in a time frame F is either smaller or larger than the old number M, the saturation power P_{SAT, M} of the power amplifier 105 is changed, preferably by the Base Band unit 101, to a second saturation power P_{SAT, N}.

This change may be performed as described above, i.e. that the Base Band unit 101 sends a control voltage GPRS_IND or any other suitable form of signal to the control unit 201 which in turn controls the last amplifier stage 219 for changing of bias voltage V_{BIAS} (line b in Figure 5), changes the setting of the match circuit 221 after the last amplifier stage 219 (line c in Figure 5), and/or bypasses the last amplifier stage 219 completely (line a in Figure 5).

The saturation power P_{SAT, N} is less than the first saturation power P_{SAT, M} if the new number N is larger than the old number M. In the opposite case, ie when the new number N is smaller than the old number M, said second saturation power P_{SAT, N} is greater than the first saturation power P_{SAT, M}·

Particular examples of the invention include the following cases: M=1, N=2, 3, or 4; M=2, N=1, 3, or 4; M=3; N=1, N=2, N=4; and M=4, N=1, 2, or 3. This can be the case, for example, in a GPRS cellular network.

Further, the output power P_{MAX, M} for M time slots in a time frame F may be lowered with a predefined step Δ = |P_{MAX, M} - P_{MAX, N}| if the new number N is larger than the old number M.

In a similar manner, the output power P_{MAX, M} for M time slots in a time frame F may be increased with a predefined step Δ = |P_{MAX, N} - P_{MAX, M}| if the new number N is smaller than the old number M.

Preferably, the output power values P_{MAX} for each number of possible number of time frames is either stored in the mobile terminal 10, or received from the mobile network 51.

## Claims

1. A method for controlling a power amplifier (105) of a radio transmitter (10) having a maximum output power (P_{MAX}, _{M}) less than the saturation power (P_{SAT, M}) of the power amplifier (105), the power amplifier (105) amplifying a signal (S) on a first number (M) of time slots in a time frame (F), **comprising the steps of:**
- receiving a target value (T) representing a second number (N) of time slots to be used, the second number (N) being larger or smaller than the first number (M); and
- responsive to receiving said target value (T), changing the first saturation power (P_{SAT, M}) to a second saturation power (P_{SAT, N}), wherein:
- said second saturation power (P_{SAT, N}) is less than the first saturation power (P_{SAT, M}) if the new number (N) is larger than the old number (M); or
- said second saturation power (P_{SAT, N}) is greater than the first saturation power (P_{SAT, M}) if the new number (N) is smaller than the old number (M).

2. A method of claim 1, further **comprising the step of:** changing the maximum output power (P_{MAX}) of the power amplifier (105) by:
- lowering it with a predefined step (|P_{MAX, N} - P_{MAX, M}|) from a previous value if the new number (N) is larger than the old number (M); or
- increasing it with a predefined step (|P_{MAX, N} - P_{MAX, M}|) if the new number (N) is smaller than the old number (M).

3. A method of claim 1 or 2, **wherein:** said changing of the saturation power (P_{SAT, M} -> P_{SAT, N}) is performed in the power amplifier (105) by:
- opening or closing a switch (SW1, SW2) on a load line () between a last amplifier stage (219) and an antenna (109);
- changing the bias voltage (V_{BIAS}) load line swiching; or
- using or bypassing a last amplifier stage (219).

4. A device (101) for controlling radio transmitter (12) adapted to amplify signal (S) on a maximum output power (P_{MAX, M}) less than the saturation power (P_{SAT, M}) of the power amplifier (105) on a first number (M) of time slots in a time frame (F), **comprising:**
- means (201) for receiving a target value (T) representing a second number (N) of time slots to be used, the second number (N) being larger or smaller than the first number (M); and
- means (201) responsive to receiving said target value (T) for changing the first saturation power (P_{SAT, M}) of th epower amplifier (105) to a second saturation power (P_{SAT, N}), wherein:
- said second saturation power (P_{SAT, N}) is less than the first saturation power (P_{SAT, M}) if the new number (N) is larger than the old number (M); or
- said second saturation power (P_{SAT, N}) is greater than the first saturation power (P_{SAT, M}) if the new number (N) is smaller than the old number (M).

5. A device (101) of claim 4, further **comprising:** means (201) for changing the maximum output power (P_{MAX}) of the power amplifier (105) by:
- lowering it with a predefined step (|P_{MAX, M} - P_{MAX, M}|) from a previous value if the new number (N) is larger than the old number (M); or
- increasing it with a predefined step (|P_{MAX, M} - P_{MAX, M}|) if the new number (N) is smaller than the old number (M).

6. A device (101) of claim 4 or 5, **wherein:** said means (201) for changing the saturation power (P_{SAT, M} -> P_{SAT, N}) are adapted to:
- open or close a switch (SW1, SW2) on a load line () between a last amplifier stage (219) and an antenna (109);
- change the bias voltage (V_{BIAS}) load line swiching; or
- use or bypass a last amplifier stage (219).

7. A mobile terminal (10) adapted to carry out the method steps of any one of claims 1 to 3.

8. A mobile terminal (10) of claim 7, **wherein:** said mobile terminal is a GPRS capable terminal, and the first and second number M, N are any of the following pairs: (1,2); (1,4); (2;1); (2;4); (4;1); (4;2).

9. A mobile terminal (10) comprising a device (101) according to any one of claims 4 to 6.

10. A mobile terminal (10) of claim 9, **wherein:** said mobile terminal is a GPRS capable terminal, and the first and second number M, N are any of the following pairs: (1,2); (1,3); (1,4); (2;1); (2;3); (2;4); (3;1); (3;2); (3;4); (4;1); (4;2); (4;3).

## Amended claims

### Amended claims in accordance with Rule 86(2) EPC.

**1.** A method for controlling a power amplifier (105) of a radio transmitter (10) having a maximum output power (P_{MAX}, _{M}) close to the saturation power (P_{SAT, M}) of the power amplifier (105), the power amplifier (105) amplifying a signal (S) on a first number (M) of time slots in a time frame (F), **comprising the steps of:**
- receiving a target value (T) representing a second number (N) of time slots to be used, the second number (N) being larger or smaller than the first number (M); and
- responsive to receiving said target value (T), changing the first saturation power (P_{SAT, M}) to a second saturation power (P_{SAT, N}), wherein:
- said second saturation power (P_{SAT, N}) is less than the first saturation power (P_{SAT, M}) if the new number (N) is larger than the old number (M); or
- said second saturation power (P_{SAT, N}) is greater than the first saturation power (P_{SAT, M}) if the new number (N) is smaller than the old number (M).

**2.** A method of claim 1, further **comprising the step of:** changing the maximum output power (P_{MAX}) of the power amplifier (105) by:
- lowering it with a predefined step (|P_{MAX, N} - P_{MAX, M}|) from a previous value if the new number (N) is larger than the old number (M); or
- increasing it with a predefined step (|P_{MAX, N} - P_{MAX, M}|) if the new number (N) is smaller than the old number (M).

**3.** A method of claim 1 or 2, **wherein:** said changing of the saturation power (P_{SAT, M} -> P_{SAT, N}) is performed in the power amplifier (105) by:
- opening or closing a switch (SW1, SW2) on a load line () between a last amplifier stage (219) and an antenna (109);
- changing the bias voltage (V_{BIAS}) load line swiching; or
- using or bypassing a last amplifier stage (219).

**4.** A device (101) for controlling radio transmitter (12) adapted to amplify signal (S) on a maximum output power (P_{MAX, M}) close to the saturation power (P_{SAT, M}) of the power amplifier (105) on a first number (M) of time slots in a time frame (F), **comprising:**
- means (201) for receiving a target value (T) representing a second number (N) of time slots to be used, the second number (N) being larger or smaller than the first number (M); and
- means (201) responsive to receiving said target value (T) for changing the first saturation power (P_{SAT, M}) of the power amplifier (105) to a second saturation power (P_{SAT,} _{N}), wherein:
- said second saturation power (P_{SAT, N}) is less than the first saturation power (P_{SAT, M}) if the new number (N) is larger than the old number (M); or
- said second saturation power (P_{SAT, N}) is greater than the first saturation power (P_{SAT, M}) if the new number (N) is smaller than the old number (M).

**5.** A device (101) of claim 4, further **comprising:** means (201) for changing the maximum output power (P_{MAX}) of the power amplifier (105) by:
- lowering it with a predefined step (|P_{MAX, M} - P_{MAX, M}|) from a previous value if the new number (N) is larger than the old number (M); or
- increasing it with a predefined step (|P_{MAX, M} - P_{MAX, M}|) if the new number (N) is smaller than the old number (M).

**6.** A device (101) of claim 4 or 5, **wherein:** said means (201) for changing the saturation power (P_{SAT, M} -> P_{SAT, N}) are adapted to:
- open or close a switch (SW1, SW2) on a load line () between a last amplifier stage (219) and an antenna (109);
- change the bias voltage (V_{BIAS}) load line swiching; or
- use or bypass a last amplifier stage (219).

**7.** A mobile terminal (10) adapted to carry out the method steps of any one of claims 1 to 3.

**8.** A mobile terminal (10) of claim 7, **wherein:** said mobile terminal is a GPRS capable terminal, and the first and second number M, N are any of the following pairs: (1,2); (1,4); (2;1); (2;4); (4;1); (4;2).

**9.** A mobile terminal (10) comprising a device (101) according to any one of claims 4 to 6.

**10.** A mobile terminal (10) of claim 9, **wherein:** said mobile terminal is a GPRS capable terminal, and the first and second number M, N are any of the following pairs: (1,2); (1,3); (1,4); (2;1); (2;3); (2;4); (3;1); (3;2); (3;4); (4;1); (4;2); (4;3).
